Europäisches Patentamt

European Patent Office

Office européen des brevets

(11) Publication number: **0 090 673**
**A2**

# EUROPEAN PATENT APPLICATION

(21) Application number: 83301884.9

(22) Date of filing: 31.03.83

(51) Int. Cl.³: **G 01 F 1/00**

(30) Priority: 31.03.82 JP 50950/82

(43) Date of publication of application: 05.10.83
**Bulletin 83/40**

(84) Designated Contracting States: **DE FR GB**

(71) Applicant: **KONISHIROKU PHOTO INDUSTRY CO. LTD.,
No. 26-2, Nishishinjuku 1-chome Shinjuku-ku,
Tokyo 160 (JP)**

(72) Inventor: **Kojima, Yasuo, 2-5-19 Owada-cho, Hachioji-shi
Tokyo (JP)**
Inventor: **Shimizu, Yoshiaki, 5-2-2 Hinodai, Hino-shi
Tokyo (JP)**

(74) Representative: **Ellis-Jones, Patrick George Armine et
al, J.A. KEMP & CO. 14 South Square Gray's Inn, London
WC1R 5EU (GB)**

(54) **Image-forming elements.**

(57) An image forming element is described which contains a photosensitive component-containing layer comprising a support having a plastics surface and having a sublayer on said plastics surface and a colored recording layer containing coloring material positioned on said sublayer in the direction in which said image forming material would be exposed. An intermediate layer which contains substantially no coloring material and dissolves or swells in a developer is positioned between said sublayer and said recording layer; this provides good adhesion between said sublayer and said recording layer.

TITLE:

IMAGE-FORMING ELEMENTS

This invention provides an image-forming element (material) containing a colored recording layer which can form high contrast images on imagewise exposed portions of said recording layer by removing non-image portions therefrom.

Japanese Patent Laid-Open Patent Publication Nos. 22929/1974 and 22930/1974 disclose the preparation of non-silver photosensitive materials, for example, those used as lithographic originals, wherein relief images are formed and dyed simultaneously on a photosensitive resin layer, or the relief images which are formed are subsequently separately dyed. This technique has the disadvantage of requiring special treatment with a dye bath containing specific dyes requiring careful control of dyeing conditions employed in the treatment for the purpose of finishing said treatment so that the treated relief images will have the requisite density.

Japanese Patent Laid-Open Patent Publication Nos. 62427/1977 and 2520/1977 disclose the preparation of image-forming materials comprising photosensitive resin layers containing dyes and pigments to avoid the aforenoted disadvantages.

Japanese Patent Laid-Open Patent Publication Nos. 16124/1972 and 89916/1977 disclose image-forming materials having a support and a colored mask layer composed of a mixture or dispersion in a high molecular binder of dyes or pigments on said support, followed by a photosensitive resin layer.

Supports having a plastic (resin) surface such as plastic films are preferably used as the supports on which the above-mentioned recording layer such as a photosensitive resin layer and a colored mask layer is provided.

When such recording layer, for example, a photosensitive resin layer and a colored mask layer as aforesaid is coated directly on the plastic surface of support, the adhesive force between the plastic surface and said recording layer is very poor, with the result that the image-forming material obtained has no practical use in most cases. On this account, a sub-layer is often provided to improve the adhesion of the plastic surface to the aforesaid recording layer, such as a colored mask layer, which is coated on such a sub-layer. When using such an intermediate layer, the above-mentioned recording layer adheres strongly and to the desired degree to the plastic surface of the support. However, when using such a sub layer it was found that dyes or pigments present in the recording layer, such as the colored mask layer, are adsorbed by said sub-layer and, even after development of said recording layer, the adsorbed dyes or pigments remain as fog in non-image portions of the developed recording layer. This is undesirable because said non-image portions should be transparent. When a sub-layer is used in which fog does not occur in the above-mentioned manner, however, the adhesive force between the layers is insufficient because the sub-layer is not diffusible between said layer and the recording layer. However, when a material capable of swelling or diffusing is selected as the layer to be disposed beneath the recording layer, such adsorption of dyes or pigments as noted hereinbefore unavoidably takes place. In that case, this adsorption is further accelerated owing to migration of the dyes or pigments from the recording layer to the sub-layer when the image-forming material associated with said sub-layer is heated or stored for a long period of time.

It is an object of the present invention to provide an image-forming material, the recording layer of which is capable of strongly adhering to a support having a plastic surface.

A further object of the invention is to provide an image-forming material which is capable of inhibiting fog formation and capable of providing high quality images.

Another object of the invention is to provide an image-forming material which has minimal degradation during storage.

A still further object of the invention is to provide an image-forming material which is capable of providing a high density and high contrast image.

The objects of the present invention can be attained in an image-forming material which comprises a support having a plastic surface coated on the exposure side thereof with a sub-layer, followed by a colored recording layer which contains a photosensitive component and an intermediate layer between said sub-layer and said colored recording layer, said intermediate layer containing substantially no coloring agent and being capable of dissolving or swelling in a developer. The invention is characterized by providing said intermediate layer between the sub-layer and the recording layer to provide an image-forming material (element) with the recording layer (and other layers) strongly adhered to the plastic support surface. The product image produced by developing this image-forming element is produced with little, if any, fog in the non-image portions of the developed recording layer.

In preferred embodiments of the present invention, said developer is water and the intermediate layer is equal, or lower than, the colored recording layer with respect to

-4-

solubility and/or swelling in the developer, and the pigment contained in the colored recording layer is carbon black.

All image-forming materials, so long as they have sequentially a support having a plastic surface and thereon, a sub-layer, and a colored recording layer containing dyes or pigments, can utilize the intermediate layer of the present invention. Fundamentally, the image-forming material according to the present invention is stratified and comprises a support having a plastic surface, a sub-layer on said support, and a colored recording layer containing dyes or pigments on said sub-layer with the intermediate layer of the present invention positioned between said sub-layer and said colored recording layer.

When non-image portions of the colored recording layer, e.g., a photosensitive resin layer, colored mask layer, etc., are irradiated with acitinic radiation and removed by dissolving or rubbing to form a colored image, the intermediate layer of the present invention is partly or wholly removed together with said non-image portions. Since the present intermediate layer contains substantially no coloring agent, even when it is provided on the sub-layer to provide the desired degree of adhesion, there is no possibility of coloring agents diffusing and migrating to be adsorbed by the sub-layer. Even when the intermediate layer partly remains unremoved, such residual intermediate layer has no adverse effect on the image which is formed because no substantial color density is retained in said layer.

The intermediate layer used in the present invention is desirably equal to or lower than the colored recording layer with respect to solubility and/or swelling in the developer. If the intermediate layer has larger solubility and/or swelling ability in the developer than the colored recording layer, the intermediate layer is removed earlier than non-image portions of the imagewise exposed recording layer disposed above said intermediate layer when the imagewise exposed image-forming material is subjected to development, whereby the developed image is fringed and its contours become indistinct, resulting in poorer quality of the image.

When water is used as the developer in prior art image-forming materials, there was a tendency for the sub-layer to adsorb dyes or pigments from the recording layer, which eventually results in fog formation in non-image portions of the developed image-forming material. In the image-forming portions of the developed image-forming material, the stratiform construction with the intermediate layer of the present invention, fog formation due to migration or adsorption of the dyes or pigments as aforesaid is substantially prevented and colored images which are sharp and have good contract can be obtained. Binders which are used for forming the intermediate layer of the present invention are selected taking into consideration characteristics of this binder used in the recording layer and the characteristics of the developer. Binders which can be used in the present intermediate layer are film-forming

-6-

and solvent-soluble high molecular weight compounds capable of dissolving or swelling in the developer which is used.

These high molecular compounds which are preferably used in the present intermediate layer include acrylic acid or methacrylic acid and alkyl esters and sulfoalkyl esters thereof; polyvinyl butyral, polyacrylamide, ethyl cellulose and cellulose derivatives such as cellulose acetate butylate, cellulose acetate propionate, cellulose acetate, benzyl cellulose, cellulose propionate, and cellulose acetate phthalate; polystyrene; polyvinyl chloride; chlorinated rubber; polysiobutylene; polybutadiene; polyvinyl acetate and copolymers thereof; etc.

When water is intended to be used as the developer for the present image-forming material, the preferred binders of the intermediate layer are water-soluble high molecular weight compounds or water-softenable high molecular weight compounds.

Water-soluble high molecular compounds used in the present intermediate compounds include such natural high molecular weight compounds, for example, casein albumin, gelatin and gum arabic; such water-soluble cellulose ethers, for example, methyl cellulose, carboxymethyl cellulose, hydroxyethyl cellulose and hydroxypropylmethyl cellulose; and such synthetic water-soluble high molecular weight compounds, for example, copolymers of maleic acid with polyacrylic acid,

-7-

polymethacrylic acid, polyacrylamide, polyvinyl
pyrrolidone, polysodium-L-glutamate, water-
soluble polyvinyl butyral, polyvinyl alcohol or vinyl
alcohol, copolymers of vinyl alcohol and acrylamide,
copolymers of (metha) acrylates and (metha) acrylic
acid, and acrylated gelatin (e.g., phthalated gelatin,
maleated gelatin, etc.), which are used either alone
or in combinations of two or more.

When using water as the developer for developing
the present image-forming materials, water-softenable
high molecular weight compounds are most preferably
used as binders of the intermediate layer. By water-
softenable high molecular compounds are meant compounds
that swell in water and whose Young's modulus decreases in the
presence of water. The moisture content of said
compounds being 1.5-30% at 80% R.H. (25°C). Preferred
water-softenable high molecular weight compounds include,
for example, methyl cellulose, ethyl cellulose, butyl
cellulose, hydroxyethyl cellulose, carboxymethyl cellulose, cyanoethyl cellulose, cellulose acetate, cellulose
triacetate, cellulose acetate butylate, cellulose acetate
phthalate, hydroxypropylmethyl cellulose phthalate,
hydroxypropylmethyl cellulose hexahydrophthalate,
polyacrylic acid esters, polymethacrylic acid esters,
polyvinyl butyral, polymethylvinyl ketone, nylon 66,
polyamide, polyvinyl methoxyacetal, polyvinyl acetate,
epoxy resin and polyurethane.

Additional polymers containing carboxy groups in
the side chains, for example, methacrylic acid copolymers,

-8-

acrylic acid copolymers, itaconic acid copolymers, partially esterified maleic acid copolymers, maleic acid copolymers and crotonic acid copolymers are also useful.

Similarly useful are addition polymers containing hydroxy, carbomoyl or dimethylamino groups, for example, vinyl alcohol copolymers, vinyl aryl alcohol copolymers, methylenediethyl malonate copolymers (reduction products), maleic anhydride copolymers (reduction products), acrylamide copolymers, methacrylamide copolymers, N,N-dimethylaminomethyl methacrylate copolymers, N,N-dimethylaminoethyl acrylate copolymers, N,N-dimethylaminoethyl methacrylate copolymers and the like.

Vinyl pyrrolidone copolymers and the like are also usable.

In the above-mentioned copolymers, mol ratios of carboxy, hydroxy, carbamoyl and dimethylamino groups vary according to the kind of comonomers used to provide the water-softenable high molecular weight compound having the desired characteristics. The aforesaid binders used as the binders for the intermediate layer can also be used as the binder for the colored recording layer. The aforementioned high molecular weight compounds (materials) are used either singly or in combination of two or more.

The intermediate layer used in the present invention can contain fillers which have substantially no color density.  Preferred fillers include such inorganic fillers as colloidal alumina sol and colloidal silica and such particulate resins as lattices.  Supports for reflective images can contain, in addition to those mentioned above, such fillers as barium sulfate, calcium carbonate, clay and silica, or such white pigments as zinc oxide, titanium oxide, white lead and antimony oxide.

The present intermediate layer preferably has a thickness of 0.05-2.0 $\mu$, and more preferably between 0.1 and 1 $\mu$, with a thickness of between 0.2 and 0.6 $\mu$ being most preferred.  When the film thickness is less than 0.05 $\mu$, practically no fog-preventing effect attributable to the intermediate layer is exhibited.  When the thickness exceeds 2.0 $\mu$, the fog-preventing effect does not increase in proportion to the increasing thickness while the development time normally required must be prolonged.  In this case, there is the possibility of bringing about problems of the coating technique concerned.  The present intermediate layer can be applied by known coating techiques, such as extrusion coating, which will be described later.  The coating solution of said intermediate layer is prepared by using a suitable solvent for the constituents used for the layer.

The supports having a plastic surface which are used in the present invention include films of plastics such as cellulose diacetate, cellulose triacetate, cellulose propionate, cellulose butylate, cellulose acetate butylate,

-10-

0090673

cellulose nitrate, polyethylene terephthalate, polyethylene, polypropylene, polystyrene, polycarbonate, polyvinyl acetal and the like, or plastic (e.g., polyethylene, polypropylene or polystyrene) laminated paper. Of the above-mentioned supports, polyethylene terephthalate-, polypropylene- or polyethylene-laminated paper is preferred.

The supports are preferably those which have previously been subjected to surface treatment comprising one or a combination of two or more treatments comprising chemical treatment, corona discharge treatment, flame treatment, ultraviolet treatment, high frequency glow discharge treatment, and active plasma treatment. By virtue of such surface treatment, when a sub-layer is to be provided on the support, there is a marked increase in the adhesive force between the sub-layer and the plastic surface of said support.

Synthetic resins for forming the sub-layer of the present invention include acrylic ester resins, vinylidene chloride resins, vinylidene chloride acrylonitrile copolymer resins, vinylidene chloride acrylonitrile itaconic acid copolymer resins, vinylidene chloride acrylonitrile methyl acrylic copolymer resins, vinyl chloride vinyl acetate maleic anhydride copolymer resins, copolymer resin of acrylic acid amide or methacrylic acid amide and alkyl ester fatty acid ester of acrylic acid or methacrylic acid, styrene or acrylonitrile, copolyester resins of phthalic acid or isophthalic acid and glycols, and polymers or copolymers

-11-

of glycidyl acrylate or glycidyl methacrylate.

In addition to those mentioned above, many synthetic resins are known as constituents for forming such sublayers. The process for preparing coating solutions for the sub-layer and coating the solution on the support may be selected from those which are conventional in this field of technology. Generally, the above-mentioned synthetic is first formed into a solution or latex by the use of water or organic solvents. The resulting solution or latex is then coated on the support according to known coating techniques, such as extrusion coating, roll coating, air knife coating and spray coating. The coating solution or latex is desirably coated on the support to a thickness of 0.05-1.0 μ.

This colored recording layer used in this invention is a layer which is first imagewise irradiated with actinic radiation. It is then developed to form a colored image after removal by dissolving or rubbing of non-image portions of the layer.

The colored recording layer comprises coloring agents such as dyes or pigments which have been dispersed, mixed or dissolved in the binder thereof. The dyes are suitably selected from ultraviolet absorbers and other dyes disclosed in Japanese Laid-Open Patent Publication No. 16124/ 1972 and the like, and the pigments from organic and inorganic pigments disclosed in the "PIGMENT MANUAL", compiled by the Japan Pigment Technology Association and said publication.

When the present image-forming material is intended to be used as a lithographic original, the colored recording layer preferably contains carbon black as the coloring agent because the colored recording layer can be made thinner to obtain the same density of image as that obtainable by the use of other pigments since carbon black has high covering power, with the result that good reproducibility of image can be attained.

Binders used in the colored recording layer according to the present invention are film-forming and solvent-soluble high molecular weight compounds, which are those preferably identified herein before as useful in the present intermediate layer.

The proportion of coloring agent to binder in the colored recording layer used in the present invention may be decided by those skilled in the art on the basis of technical knowledge well known to the art, taking into account the desired optical density and the removability of the colored recording layer when treated with a developer. In the case of dyes, for instance, the amount thereof to be incorporated into the colored recording layer is suitably 5-75% by weight, and the pigment content is suitably 5-90% by weight. In particular, when the colored recording layer comprising a water-softenable high molecular weight compound as a binder and a pigment as a coloring agent and is intended to be developed with water, the coloring agent/binder proportion is desirably at least 1.0/2.0.

-13-

The thickness of the present colored recording layer may be decided by those skilled in the art, according to known technical information, on the basis of the desired optical density (e.g., 3.0-4.0 as measured with a Macbeth illuminometer), and the kind and content of the coloring agent (e.g., dye, pigment or carbon black) used in the colored recording layer. When the colored recording layer is designed to have a thickness falling within the permissible range, the thinner the layer, the higher is the resolving power and the more favorable the formed image.

The colored recording layer may contain a photosensitive component so long as said component does not adversely affect the film-forming properties of the binder used in said recording layer. Usable photosensitive components are those which produce, when irradiated with actinic radiation, a difference between the exposed and unexposed portions thereof with respect to solubility or swelling in the developer which is used. Photosensitive components of the so-called negative-working type, wherein the portions exposed to actinic radiation decrease in solubility or swelling in the developer, include photolinking type photosensitive resins illustrated by the esterified product of polyvinyl alcohol with cinnamic acid, diazonium salts or condensation products thereof, and aromatic amide compounds. Useful photosensitive components also include photosensitive resins such as those obtained by utilizing photoradical or photoionic polymerization.

-14-

Photosensitive components of the so-called positive-working type wherein the portions exposed to actinic radiation become higher in solubility or swelling in the developer which is used, such as napthoquinone diazide compounds and the like can also be used.

The image-forming materials of the present invention preferably have a stratiform construction such that a photosensitive layer composed of a photosensitive composition is provided on the colored recording layer. Such a photosensitive layer is indispensable for the present image-forming material when the colored recording layer of said image-forming material does not contain a photosensitive component.

Compositions for forming such photosensitive layer are well known and commercially available products are readily available. Compositions useful for this purpose include all compounds, such as monomers, prepolymers and polymers, which (1) undergo chemical change of their molecular structure in a short time when irradiated with actinic radiation, (2) change their solubility in solvents, and which are dissolved and removed when certain solvents are applied thereto. Useful photosensitive compositions of the so-called negative working type, wherein the solvent solubility of the exposed portions decreases, include photolinking type photosensitive resins illustrated by the esterified product of polyvinyl alcohol with cinnamic acid; systems comprising mixtures of diazonium salts or condensation products thereof with polyvinyl alcohol, polyvinyl pyrrolidone, polyacrylamide

-15-

or the like; and systems comprising mixtures of aromatic azide compounds used as photolinking agents with binders such as cyclized rubber or the like. They also include photosensitive resins obtained by utilizing photoradical or photoionic polymerization. Photosensitive compositions of the so-called positive-working type, in which the solvent solubility of the exposed portions increases, such as soluble type resin systems illustrated by the combination of naphthoquinone and novolak resin can also be used.

Commercially available products of such photosensitive compositions as referred to above include "KPR", "KOR" and "KMER" produced and sold by Eastman Kodak, USA, "AZ-340", "AZ-119" and "AZ-1350" by Schipley Co., USA, "TPR" and "Ohoka Resist" by Tokyo Ohoka K.K., and "FPPR" by Fuji Yakuhin K.K., and all these products are usable in the present invention.

Solvents used for removing non-image portions of the photosensitive layer used in the present invention may be the same as or different from the developer used for developing the present image-forming materials. It is needless to say, however, that the use of the same solvent as the developer is desirable since the number of development steps can be reduced.

In light of the possibility of developing the present image-forming material in a single bath process using water as the developer, the photosensitive layer used in said image-forming material should be capable of being developed with water.

-16-

As a photosensitive layer which will answer the above purpose, there may be mentioned photosensitive layers comprising diazo resins and high molecular compounds having quaternary nitrogen atoms or quaternary phosphorus atoms (Japanese Patent Appln. No. 147629/1982), photosensitive layers comprising water-softenable high molecular compounds (Japanese Patent Appln. No. 119332/1981), and photosensitive layers comprising water-insoluble granular dispersions (Japanese Patent Appln. No. 41690/1982).

In the image-forming materials of the present invention, an overcoat layer which dissolves or swells at the time of development in the developer can be provided to prevent the surface of image-forming material from scratching to prevent a photopolymerization inhibiting effect caused by oxygen, or to improving airtightness.

This overcoat layer may be a resin layer which has been mechanically matted or which contains matting agents. Such matting agents include silicon dioxide, zinc oxide, titanium oxide, zirconium oxide, glass powder, alumina, starch, particulate polymers, and such matting agents as disclosed in U.S. Patent Nos. 2,701,245 and 2,992,101. These matting agents may be used in combinations of two or more, and the resins used in the overcoat layer will be selected dependant upon the developer which will be used.

Resins which are usable in the overcoat layer are, for example, gum arabic, glue, gelatin, casein, celluloses, starches, polyvinyl alcohol, polyethylene oxide, polyacrylic acid, polyacrylamide, polyvinyl methyl ether, polyvinyl

-17-

pyrrolidone and polyamide, which may be used either alone or in combinations of two or more.

The image-forming material can be prepared by dissolving the aforesaid constituents for the intermediate layer and those for the colored recording layer, separately, suitable solvents to prepare their respective coating solutions which are then coated sequentially or simultaneously in the desired order on the surface of the aforesaid sub-layer which has previously been provided on the support. The solvents used in the above process may be water, methanol, ethanol, acetone, ethyl acetate, methyl cellosolve, ethyl cellulose, dioxane, methyl ethyl ketone, cyclohexane, $\gamma$-butyrolactone, tetrahydrofuran, methylene chloride, ethylene chloride, dimethyl sulfoxide and dimethyl formaide, which may be used either alone or in combinations of two or more.

The thus prepared image-forming material in accordance with the present invention is imagewise exposed to actinic radiation.

Various light sources may be used, such as a super high pressure mercury lamp, tungsten lamp, mercury lamp, xenon lamp, fluorescent lamp, CRT light source, laser light source, etc.

To form an image on the thus imagewise exposed image-forming material, said material is first treated with a solvent which does not dissolve image portions of the colored recording layer and the photosensitive layer but dissolves non-image portions thereof, whereby the non-image portions of the photosensitive layer are removed to form a resist image on the photosensitive layer. This material is then treated with a solvent as a developer, which dissolves or swells the colored recording layer but does not dissolve the resist image formed on the photosensitive layer, whereby the portions of the colored recording layer laid bare after removal of the aforesaid non-image portions of the photosensitive layer are dissolved or removed by rubbing. Alternatively, this material is then treated with a solvent which does not dissolve the aforesaid image portion of the photosensitive layer but is capable of dissolving and/or swelling both the non-image portions of the photosensitive layer and the colored recording layer, whereby the image is formed by simultaneously dissolving the non-image portions of the photosensitive layer and colored recording layer and removing by rubbing said non-image portions. Simultaneously, with this development of the colored recording layer, at least part of the present intermediate layer is removed along with said colored recording layer.

To develop the photosensitive layer and colored recording layer in the manner explained above, it is important to select suitable solvents. In either case, the present invention can be practiced using conventional well-known techniques hitherto employed in this field of the art.

The image-forming materials of the present invention can be processed to the desired images having extremely high image density and very low fog density, and when they

-19-

0090673
are prepared using a transparent support, they have the industrial advantages that they are quite useful as conversion print photosensitive materials which are well suited for making a lithographic printing original, and in the step of reproducing a copy of design drawings and of microphotographs. The image-forming materials of the present invention also have the advantage of good stability during the service (storage and transport) period before use.

The present invention is illustrated by the following examples. Embodiments of the invention are not limited to these examples.

Example 1

On a vinylidene chloride type resin sub-layer which is on a polyethylene terephthalate film support was coated a coating solution of the following composition to form an intermediate layer having a dry film thickness of 0.5 $\mu$, followed by drying.

| | |
|---|---|
| Hydroxypropylmethyl cellulose hexahydrophthalate | 1 parts by weight |
| Methyl cellosolve | 50 parts by weight |
| Acetone | 50 parts by weight |

Subsequently, on the intermediate layer was coated a colored recording layer of the following composition to form a layer having a dry film thickness of 2 $\mu$, followed by drying.

0090673

| Hydroxypropylmethyl cellulose hexahydrophthalate | 20 parts by weight |
| Carbon black | 10 parts by weight |
| Acetone | 600 parts by weight |
| Methyl cellosolve | 150 parts by weight |

On this colored recording layer was coated a photoresist (TPR produced and sold by Tokyo Ohka Kogyo K.K.) by means of a rotary coater to form a layer having a dry film thickness of 1.5 μ, followed by drying.

On the image-forming material of the present invention thus prepared was superposed a halftone dot original, and the image-forming material was then exposed to light for 20 seconds at a distance of 80 cm from a 3KW metal halide lamp. The exposed image-forming material was then immersed in 1,1,1-trichloroethylene to wash out unexposed portions of the photosensitive layer and successively softly rubbing the surface of the photosensitive layer with a sponge for about 20 seconds, while said layer was immersed in a water bath, whereupon portions of the colored recording layer exposed after removal of the photosensitive layer are removed to obtain a clear black image.

The thus obtained image was tested for fog density with a densitometer (POA-65; manufactured by Konishiroku Photo Industry Co., Ltd.). The fog density was 0.05.

Another sample of the image-forming material prepared in this example was stored for 4 days in an atmosphere

-21-

of 80% RH (relative humidity) at 40°C, and then subjected to exposure and development in the same manner as described hereinbefore. Fog density of the resultant image was also 0.05. It was confirmed that the present image-forming material has stable characteristics during storage, even under high humidity conditions.

The present image-forming material was subjected to the scotch tape peeling test wherein a cellophane tape (cellophane adhesive tape; produced and sold by Nichiban Co., Ltd.) was attached to the surface of the image-forming material and then peeled off whereupon the colored recording layer which was strongly adhered to the support did not peel off with the tape.

The foregoing establishes that the image-forming material of this invention has low fog density, excellent storage characteristics and good adhesion between the support and the colored recording layer.

Comparative Example 1

A comparative sample was prepared in exactly the same manner as in Example 1, except that the intermediate layer was not provided, and the comparative sample was exposed, developed and tested for fog density in the same manner as in Example 1 to obtain a fog density of 0.12 in the resultant image. Separately, this comparative sample was stored for 4 days at 40°C and 80% RH, followed by exposure and development in the same manner as above. The image obtained was tested for fog density. The fog density thereof was 0.34.

-22-

Thus, the comparative image-forming material without the intermediate layer had high fog density and tended to deteriorate during storage.

Comparative Example 2

A comparative sample was prepared in exactly the same manner as in Example 1, except that the sub-layer and the intermediate layer were not provided, and the sample was exposed and developed in the same manner as in Example 1. Many defects were observed in small dot portions of the halftone dot image. This comparative sample was subjected to the scotch tape peeling test in the same manner as in Example 1, whereupon the recording layer corresponding to more than 80% of the area to which the scotch tape was attached was peeled off together with said tape. The comparative image-forming material without the sub-layer and intermediate layer according to the present invention was found to have insufficient adhesion between the support and the colored recording layer.

Example 2

On a vinylidene chloride type resin sub-layer which was on a polyethylene terephthalate film support was coated a coating solution of the following composition to form an intermediate layer having a dry film thickness of 0.5 $\mu$, followed by drying.

| | |
|---|---|
| HP-50 (hydroxypropylmethyl cellulose phthalate; produced and sold by The Shin-etsu Chem. Ind. Co., Ltd.) | 1 part by weight |
| SNOTEX O (20% aq. colloidal silica dispersion; produced and sold by Nissan Chem. Inds. Ltd.) | 5 parts by weight |

Methyl cellosolve                           100 parts by weight

On the intermediate layer thus formed was coated a colored recording layer of the following composition to form a layer having a dry film thickness of 1.5 μ, followed by drying.

HP-50 (the same as mentioned above      1 part   by weight
Carbon black                            1 part   by weight
Methyl cellosolve                      20 parts by weight

On this colored recording layer was coated a photosensitive layer of the following composition to form a layer having a dry film thickness of 1.5 μ.

Poly(styrene-co-N,N,N-trimethyl-N-vinylbenzyl ammonium chloride) (9:1)
10% water/ethanol = 3/1 solution      80 parts by weight

Diazo No. 4 (diazo resin produced and sold by Fairmount Chemical Co.) 10% aq. soln.                                20 parts by weight

The image-forming material of the present invention thus prepared was exposed, after superposing thereon a halftone dot original, for 40 seconds to light at a distance of 80 cm from a 3 KW metal halide lamp, and the exposed image-forming material was immersed in a water bath and softly rubbed for about 45 seconds in said bath, whereupon uncured portions of the photosensitive and colored recording layers were removed and a clear black image without fog was obtained.

Example 3

On a vinylidene chloride type resin sub-layer which was on a polypropylene synthetic paper support was coated a coating solution of the following composition to form an intermediate layer having a dry film thickness of 0.3 $\mu$, followed by drying.

<div style="margin-left: 2em;">

Gosenol GL-05 (polyvinyl alcohol produced and sold by The Nippon Synthetic Chem. Ind. Co., Ltd.) 10% aq. soln.      20 parts by weight

Glyoxal 3.5% aq. soln.      1 part by weight

</div>

On this intermediate layer was coated a colored recording layer of the following composition to form a layer having a dry thickness of 1.0 $\mu$, followed by drying.

<div style="margin-left: 2em;">

10% aqueous gelatin solution      100 parts by weight

Carbon black      5 parts by weight

Water      100 parts by weight

</div>

The image-forming material thus prepared was exposed and developed in the same manner as in Example 1 to obtain a clear black image without fog.

Example 4

On a vinylidene chloride type resin sub-layer which was on a polyethylene terephthalate film support was coated a coating solution of the following composition to form an intermediate layer having a dry film thickness of 1.0 $\mu$, followed by drying.

Hydroxyethyl methacrylate ethyl
methacrylate (3:7) copolymer      1 part by weight

Aluminasol 200 (20% solids; produced
and sold by Nissan Chem. Ind., Ltd.)      3 parts by weight

Methyl cellosolve      100 parts by weight


On this intermediate layer was coated a colored recording layer of the following composition to form a layer having a dry film thickness of 3 $\mu$.


| Hydroxyethyl methacrylate ethyl methacrylate (3:7) copolymer | 3 parts by weight |
| --- | --- |
| Carbon black | 1 part by weight |
| Methyl cellosolve | 50 parts by weight |


On this colored recording layer was coated a photosensitive layer of the following composition to form a dry film thickness of 5 $\mu$.


| Styrene methacrylic acid (7:3) copolymer | 5 parts by weight |
| --- | --- |
| Aronix M-8060 (produced and sold by Toa Gosel Chem. Ind. Co., Ltd.) | 5 parts by weight |
| Isopropyl thioxanthone | 1 part by weight |
| Dimethylaminobenzoate, isopropyl | 1 part by weight |
| Hydroquinone | 0.05 part by weight |
| Methyl cellosolve acetate | 100 parts by weight |

On this colored recording layer was coated an overcoat layer of the following composition to form a layer having a dry film thickness of 3 $\mu$.

Gosenol GL-05 (polyvinyl alcohol produced
and sold by The Nippon Synthetic Chem.
Ind. Co., Ltd.)                              1  part by weight

Water                                       10 parts by weight

The image-forming material of the present invention thus prepared was exposed in the same manner as in Example 1, immersed for 60 seconds in SDP-1 (produced and sold by Konishiroku Photo. Ind. Co., Ltd.) solution diluted to seven times, and then water washed, whereupon a clear black image without fog was obtained.

Example 5

On a polyethylene terephthalate film support were coated a sub-layer and an intermediate layer in the same manner as in Example 1. On the thus formed intermediate layer was coated a colored recording layer of the following composition to form a layer having a dry film thickness of 3.0 $\mu$, followed by drying.

Viny 1 acetate n-butyl acrylate copolymer
latex (20% solids)                          35 parts by weight

Diazo No. 4 (same as mentioned above)        1 part  by weight

Carbon black                                  2 parts by weight

Water                                        60 parts by weight

The image-forming material of the present invention thus prepared was exposed to light and developed with water in the same manner as in Example 1, whereupon a clear black image without fog was obtained.

- 28 -

## C L A I M S

1. An image forming element which contains a photosensitive component-containing layer comprising a support having a plastics or resin surface, a sublayer on one or the said plastics surface, a colored recording layer containing coloring material over said sublayer, and an intermediate layer, which contains substantially no coloring material and which is capable of dissolving or swelling in a developer, positioned between said sublayer and said recording layer.

2. An element according to claim 1, wherein said intermediate layer is from 0.05 to 2 $\mu$ thick.

3. An element according to claim 1 or 2, wherein said intermediate layer and said colored recording layer dissolve or swell in water as the developer.

4. An element according to any one of claims 1 to 3, wherein said intermediate layer has a solubility and/or swellability in said developer which is less than or equal to the corresponding solubility and swellability of said colored recording layer.

5. An element according to any one of the preceding claims, wherein said colored recording layer contains a pigment.

6. An element according to claim 5, wherein said pigment is carbon black.

7. An element according to any one of the preceding claims, wherein said intermediate layer comprises at least one water soluble resin.

8. An element according to any one of the preceding claims wherein said recording layer comprises a water soluble resin.

9. An element according to claim 7 or 8, wherein the water soluble resin is casein, albumin, gum arabic, methyl cellulose, carboxymethyl cellulose, hydroxyethyl cellulose, hydroxypropylmethyl cellulose; a copolymer of maleic acid and acrylic acid, methacrylic acid, acrylamide or vinyl pyrrolidone, polysodium-L-glutamate, a water-soluble polyvinyl butyral, polyvinyl alcohol or vinyl alcohol, a copolymer of vinyl alcohol and acrylamide, a copolymer of (metha)-acrylate and (metha)acrylic acid, or acylated gelatin.

10. An element according to any one of claims 1 to 6 wherein said intermediate layer comprises at least one water softenable resin.

11. An element according to any one of claims 1 to 7, 9 and 10, wherein said recording layer comprises a water-softenable resin.

12. An element according to claim 10 or 11, wherein the water softenable resin is methyl cellulose, ethyl cellulose, butyl cellulose, hydroxyethyl cellulose, carboxymethyl cellulose, cyanoethyl cellulose, cellulose acetate, cellulose triacetate, cellulose acetate butylate, cellulose acetate phthalate, hydroxypropylmethyl cellulose phthalate, hydroxypropylmethyl cellulose hexahydrophthalate, a polyacrylic acid ester, a polymethacrylic acid ester, polyvinyl butyral, polymethylvinyl ketone, nylon 66, a polyamide, polyvinyl methoxyacetal, polyvinyl acetate, epoxy resin, polyurethane, methacrylic acid copolymer, acrylic acid copolymer, itaconic acid copolymer, partially esterified maleic acid copolymer, maleic acid copolymer, crotonic acid copolymer, vinyl alcohol copolymer, vinyl aryl alcohol copolymer, methylenediethyl malonate copolymer (reduction product), maleic anhydride copolymer (reduction product), acrylamide copolymer, methacrylamide copolymer, N,N-dimethylaminomethyl methacrylate copolymer, N,N-dimethylaminoethyl acrylate copolymer, or N,N-dimethylaminoethyl methacrylate copolymer.

13. An element according to any one of the preceding claims, wherein said sublayer comprises at least one resin which is an acrylic ester resin, vinylidene chloride resin, vinylidene chloride-acrylonitrile copolymer resin, vinylidene chloride-acrylonitrile-itaconic acid copolymer resin, vinylidene chloride-acrylonitrile-methacrylate copolymer resin, vinyl chloride-vinyl acetate-maleic anhydride copolymer resin, a copolymer resin of acrylamide or methacrylamide, an alkyl ester fatty acid ester of acrylic acid or methacrylic acid, styrene, acrylonitrile, a copolyester resin of phthalic acid or isophthalic acid and a glycol, or a polymer or copolymer of glycidyl acrylate or glycidyl methacrylate.

14. An element according to any one of the preceding claims, wherein said support is of cellulose diacetate, cellulose triacetate, cellulose propionate, cellulose butyrate, cellulose acetate butyrate, cellulose nitrate, polyethylene terephthalate, polyethylene, polypropylene, polystyrene, polycarbonate, polyvinyl acetal or as a plastics laminated paper.

15. An element according to any one of the preceding claims, wherein said intermediate layer contains one or more fillers which have substantially no color density.

16. An element according to claim 15 wherein the filler is colloidal alumina, colloidal silica, or latex particles.

17. An element according to any one of the preceding claims, wherein the recording layer contains 5% to 95% by weight of coloring agent.

18. An element according to claim 17, wherein the recording layer contains 5% to 75% by weight of coloring agent and the coloring agent/resin weight ratio is at least 1:2.

19. An element according to any one of the preceding claims which comprises a photosensitive layer in addition to said recording layer.

20. An element according to claim 19, wherein said photosensitive layer, said intermediate layer and said colored recording layer are dissolvable or swellable in water as a developer, said layers each comprising a water-soluble or water-softenable resin, the intermediate layer contains one or more of colloidal alumina, colloidal silica and latex particles as filler and has a thickness of 0.1 to 1 $\mu$; and the recording layer contains 5% to 75% by weight of coloring agent and the coloring agent/ resin weight ratio is at least 1:2.

21. A method of forming an image which comprises imagewise exposing an element as claimed in any one of the preceding claims from the side of the colored recording layer, dissolving off the non-image portions of the colored recording layer and treating the resulting material with a developer which dissolves or swells the colored recording layer.